# EUROPÄISCHE PATENTSCHRIFT

(11) **EP 1 174 922 B1**
(45) Veröffentlichungstag und Bekanntmachung des Hinweises auf die Patenterteilung: **12.09.2007**
(21) Anmeldenummer: 01116397.9
(22) Anmeldetag: 06.07.2001
(51) Int. Cl.: H01L 23/66, H01L 23/48

(54) **Gehäuse für eine integrierte Schaltung mit Koplanarleitungen**
Intergrated circuit package with coplanar transmission lines
Boîtier pour un circuit intégré avec lignes de transmission coplanaires

(30) Priorität: 18.07.2000 DE 20012450 U
(43) Veröffentlichungstag der Anmeldung: 23.01.2002
(73) Patentinhaber: Rosenberger Hochfrequenztechnik GmbH & Co. KG, 83413 Fridolfing (DE)
(72) Erfinder: Rosenberger, Bernd, 83413 Fridolfing (DE)
(74) Vertreter: Zeitler, Giselher

(56) Entgegenhaltungen:
- EP-A- 0 337 485
- EP-A- 0 441 180
- EP-A- 0 563 969
- DE-C- 4 404 312
- US-A- 4 600 907
- US-A- 5 194 932

## Beschreibung

Die Erfindung betrifft ein Gehäuse für eine integrierte Schaltung gemäß dem Oberbegriff des Anspruchs 1.

Herkömmlicherweise werden Kontaktverbindungen zwischen den Kontaktflächen auf dem Substrat und den am Gehäuse außenliegenden Kontaktpins zum Kontaktieren einer Schaltung einer Leiterplatte mittels Bonden hergestellt. Dies ist jedoch aufwendig und kostenintensiv. Darüber hinaus ergeben sich für diese Bondkontakte nicht vorhersehbare Hochfrequenzeigenschaften, welche ggf. zu entsprechender Verlustleitung mit Wärmeentwicklung führen können.

Aus Dokument EP 0 337 485 A2 ist eine Halterung für ein IC bekannt, bei der eine äußere Kontaktierung der Kontakte des ICs über die Halterung erfolgt. Hierbei ist eine HF-Kontaktelektroden als koplanarer Wellenleiter ausgebildet. EP 0 337 485 offenbart den Oberbegriff des Anspruchs 1 der vorliegenden Anmeldung.

Aus Dokument EP 0 563 969 A2 ist ein Übertragungsband für ein HF-Signal zum gleichzeitigen Kontaktieren von mehreren IC-Chips mit einer Signalübertragungsleitung bekannt. Dieses Band umfasst eine dünne, isolierende Schicht an deren einer Oberfläche Signalleitungen angeordnet sind.

Aus Dokument US 4 600 907 ist eine koplanare Mikrostreifenleitung bekannt, die als elektrische Verbindung zwischen zwei Halbleiterbauteilen dient. Die Mikrostreifenleitung umfasst mehrere dünne Streifen aus elektrisch leitendem Werkstoff, die in Polyimidsubstrat eingebettet sind und elektrische Eigenschaften wie ein koplanarer Wellenleiter aufweisen. Die Wellenleiterstruktur stellt eine Impedanzanpassung zwischen den beiden Halbleitertiauteilen her.

Es ist Aufgabe der vorliegenden Erfindung, ein Gehäuse der o.g. Art zur Verfügung zu stellen, welches eine einfachere Kontaktierung und bessere Eigenschaften bezüglich hochfrequenter Signalweiterleitung zur Verfügung stellt.

Diese Aufgabe wird durch die Erfindung mit den im Anspruch 1 gekennzeichneten Merkmalen gelöst. Vorteilhafte Ausgestaltungen ergeben sich aus den weiteren Ansprüchen.

Dazu ist es erfindungsgemäß vorgesehen, dass zwischen dem Dielektrikum und dem Kontaktende die einzelnen koplanaren Leiter der koplanaren Leiterstruktur derart ausgebildet sind, dass sie bzgl. des halternden Dielektrikums federnd angeordnet sind; dass die am Gehäuse vorgesehenen Kontakte wenigstens teilweise als Koaxialverbinder zum Anschluss eines Koaxialkabels ausgebildet sind und dass der Koaxialverbinder als Winkelverbindungselement zum gehäuseseitigen elektrischen Verbinden einer jeweiligen koplanaren Leiterstruktur mit einer koaxialen Wellenleiterstruktur ausgebildet ist und ein koplanarstrukturseitiges Anschlussteil zum Verbinden mit den koplanaren Leitern einer der koplanaren Leiterstrukturen sowie einen koaxialstrukturseitigen Koaxanschluss umfasst, der mit einer Koaxialleitung verbindbar ist, wobei das koplanarstrukturseitige Anschlussteil innerhalb des Außenumfangs des Winkelverbindungselementes mit einem Innenleiterstift des Koaxanschlusses verbunden ist und als planarer Wellenleiter mit definiertem Wellenwiderstand ausgebildet ist, der ein dielektrisches Substrat und einen Streifenteiter aufweist, wobei innerhalb des Gehäuses des Winkelverbindungselementes der Innenleiterstift des Koaxanschlusses durch das Substrat hindurch mit dem Streifenleiter verbunden ist.

Durch eine impedanzkontrollierte Kontaktierung zwischen dem Substrat und dem Gehäuse wird eine Reduzierung von Verlustleistungen, beispielsweise durch Reflexion von Hochfrequenzenergie an Sprungstellen der Impedanz und somit eine geringere Erwärmung bzw. thermische Belastung erzielt , so dass problemlos integrierte Schaltungen mit hohen Taktraten, wie beispielsweise Computerprozessoren (CPU), in das erfindungsgemäße Gehäuse integriert werden können. Gleichzeitig sind keine Änderungen in bisherigen Herstellungsprozessen für die integrierten Schaltungen notwendig, so dass das erfindungsgemäße Gehäuse einfach und problemlos in bestehende Produktionsanlagen implementiert werden kann.

Eine einfache und kostengünstige Montage der integrierten Schaltung in dem Gehäuse kann man dadurch erzielen, dass die Kontaktleiter des Gehäuses derart eigenstabil und flexibel ausgebildet und angeordnet sind, dass sie bei in dem Gehäuse angeordneter, integrierter Schaltung entsprechende Kontaktflächen des Substrats mit entsprechenden Kontaktdrücken zum Herstellen jeweiliger elektrischer Kontaktverbindungen kontaktieren. Hierbei muss nicht jeder Kontakt einzeln hergestellt werden, wie das beispielsweise bei Bonddrähten der Fall ist.

Eine optimale Impedanzanpassung mit ggf. gleichzeitiger Impedanzwandlung zwischen den Kontaktflächen des Substrats und den am Gehäuse vorgesehenen Kontakten kann man dadurch erzielen, dass die koplanaren Kontaktleiter derart ausgebildet sind, dass deren Impedanz an einem den Kontaktflächen des Substrats zugewandten Ende einer Ausgangsimpedanz an den jeweils kontaktierten Kontaktflächen auf dem Substrat entspricht.

Beispielsweise ist die integrierte Schaltung ein Halbleiterchip, wie beispielsweise ein Computerprozessor (CPU).

Zweckmäßigerweise sind die am Gehäuse vorgesehenen Kontakte wenigstens teilweise als Stifte (Pins) zur Oberflächenbefestigung des Gehäuses auf einer Leiterplatte ausgebildet.

Zur kontrollierten Impedanzanpassung ist in einer bevorzugten Ausführungsform zwischen je zwei Leitern wenigstens einer koplanaren Leiterstruktur von dem Kontaktende bis zu den am Gehäuse vorgesehenen Kontakten ein jeweiliger Spalt derart ausgebildet, dass sich vom Kontaktende bis zu den am Gehäuse vorgesehenen Kontakten ein vorbestimmter konstanter oder vorbestimmt sich ändernder Wellenwiderstand ergibt. Sofern ein Dielektrikum vorgesehen ist, ist dementsprechend der jeweilige Spalt im Bereich des Dielektrikums breiter ausgebildet als im Bereich der koplanaren Leiterstruktur ohne Dielektrikum.

Das Substrat des Koaxialverbinders ist beispielsweise aus Polytetrafluorethylen gefertigt und der planare Wellenleiter ist bevorzugt als Mikrostreifenleitung oder koplanare Leitung ausgebildet. Am Koaxanschluss ist zweckmäßigerweise ein Schraub- oder Klemmanschluss zur Befestigung einer Koaxialleitung vorgesehen. Der planare Wellenleiter ist bevorzugt senkrecht zum Koaxanschluss angeordnet.

Für eine besonders verlustarme Übertragung von Hochfrequenzsignalen von der integrierten Schaltung zu den Kontakten am Gehäuse sind wenigstens einige der Kontaktflächen auf dem Substrat wenigstens teilweise als koplanare Leiterstruktur ausgebildet.

Die Erfindung wird im Folgenden anhand der Zeichnung näher erläutert. Es zeigen:
- Fig. 1: eine bevorzugte Ausführungsform eines erfindungsgemäßen Gehäuses mit IC in schematischer, teilweise aufgebrochener Seitenansicht und
- Fig. 2: in schematischer Aufsicht.

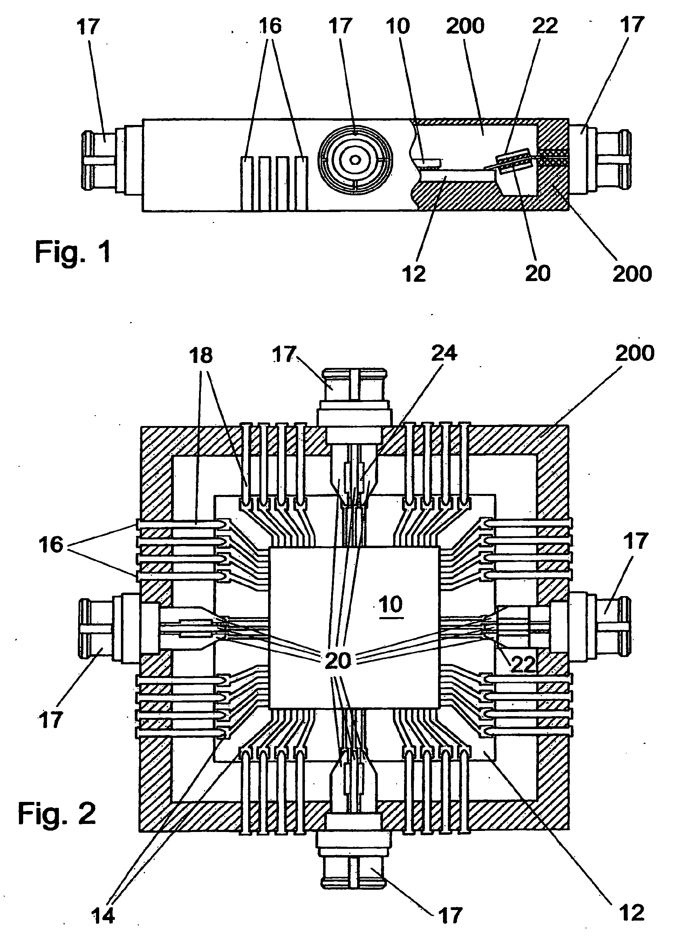

Die in Fig. 1 und 2 dargestellte bevorzugte Ausführungsform eines erfindungsgemäßen Gehäuses 200 für einen integrierten Schaltkreis 10 auf einem Substrat 12, welches elektrisch mit dem integrierten Schaltkreis 10 verbundene Kontaktflächen 14 aufweist, umfasst Kontakte 16, 17, die außen am Gehäuse 200 zum Kontaktieren einer Schaltung einer nicht dargestellten Leiterplatte dienen und die innen im Gehäuse 100 mit den Kontaktflächen 14 auf dem Substrat 12 elektrisch zu verbinden sind.

Zum Herstellen einer elektrischen Verbindung zwischen den Kontaktflächen 14 auf dem Substrat 12 und den Kontakten 16, 17 am Gehäuse 200 sind Kontaktleiter 18, 20 vorgesehen, welche in ihrer Gesamtheit eine Kontaktleiteranordnung ausbilden. Diese Kontaktleiteranordnung ist derart ausgebildet, dass jeweilige vom Gehäuse 200 abgewandte Enden der Kontaktleiter 18, 20 bei in dem Gehäuse 200 eingesetzten Substrat 12 an entsprechenden Orten der Kontaktflächen 14 auf dem Substrat 12 angeordnet sind. Durch eine entsprechende Eigenstabilität und federnde Elastizität der Kontaktleiter 18, 20 ergeben sich automatisch bei der Montage des integrierten Schaltkreises 10 in dem Gehäuse 200 entsprechende elektrische Kontakte zwischen den Kontaktleitern 18, 20 und den Kontaktflächen 14 auf dem Substrat 12, indem die jeweiligen Kontaktleiter 18, 20 mit ihrem jeweiligen freien Ende auf die Kontaktflächen 14 mit entsprechender Kraft drücken. Die Kontaktleiter 14 sind dazu ferner entsprechend eigenstabil ausgebildet.

Während die Kontaktleiter 18 innerhalb des Gehäuses 200 stiftartig ausgebildet sind, haben die Kontaktleiter 20 einen Aufbau als koplanare Leiterstruktur mit vorbestimmter Impedanz. Hierdurch erfolgt eine entsprechend impedanzangepasste Signalübertragung über die Kontaktleiter 20 von den Kontaktflächen 14 auf dem Substrat 12 zu den am Gehäuse außenliegenden Kontakten 17.

Bei der in Fig. 1 und 2 dargestellten bevorzugten Ausführungsform eines erfindungsgemäßen Gehäuses 200 sind die den koplanaren Kontaktleitern 20 zugeordneten Kontakte 17 außen am Gehäuse 200 als Koaxialverbinder 17 zum Anschluss eines Koaxialkabels ausgebildet. Ferner ist eine aus drei Kontaktleitern 20 gebildete koplanare Leiterstruktur mit einem Dielektrikum 22 versehen.

Hiedurch ist eine verlustarme, impedanzkontrollierte Herausführung von Hochfrequenzsignalen über die Kontaktleiter 20 und Kontakte 17 aus dem Gehäuse 100, 200 heraus zu einer außen liegenden Schaltung gewährleistet. Dies vermindert beispielsweise thermische Belastungen der integrierten Schaltung 10 innerhalb des Gehäuses 100, 200. Umgekehrt ist es möglich, bei gleich bleibender thermischer Belastung die integrierte Schaltung 10 mit höherer Taktrate zu betreiben.

Es bilden jeweils drei Kontaktleiter 20 eine koplanare Leiterstruktur aus, wobei zwischen den Kontaktleitern 20 jeweils ein Spalt 24 derart ausgebildet ist, dass sich vom Kontaktende bis zu den am Gehäuse 200 vorgesehenen Kontakten 17 ein vorbestimmter konstanter oder vorbestimmt sich ändernder Wellenwiderstand ergibt. Ein mittlerer Kontaktleiter 20 dieser koplanaren Leiterstruktur ist dabei ein Signalleiter, während die beiden anderen Kontaktleiter 20 dieser koplanaren Leiterstruktur Massekontakte sind.

## Patentansprüche

1. Gehäuse (200) mit einem Substrat (12), welches zur Aufnahme einer integrierten Schaltung (10) ausgebildet ist, wobei das Substrat (12) zum Herstellen von elektrisch leitenden Kontaktverbindungen zwischen der integrierten Schaltung (10) und am Gehäuse (200) vorgesehenen Kontakten (16, 17) entsprechende Kontaktflächen (14) aufweist, die zum elektrischen Verbinden mit entsprechenden Kontakten an der integrierten Schaltung (10) ausgebildet sind, wobei das Gehäuse (200) eine Anordnung von Kontaktleitern (18, 20) aufweist, welche mit den am Gehäuse (200) vorgesehenen Kontakten (16, 17) elektrisch verbunden sind und sich mit der Anordnung der Kontaktflächen (14) auf dem Substrat (12) derart decken, dass die Kontaktleiter (18, 20) die Kontaktflächen (14) mit einem jeweiligen Kontaktende kontaktieren, wobei wenigstens einige der Kontaktleiter (20) als koplanare Leiterstruktur ausgebildet sind, wobei auf wenigstens einer koplanaren Leiterstruktur über einen vorbestimmten Abschnitt zwischen dem Kontaktende und den Gehäusekontakten (17) wenigstens einseitig ein die koplanare Leiterstruktur halterndes Dielektrikum (22) angeordnet ist,
**dadurch gekennzeichnet,**
**dass** zwischen dem Dielektrikum (22) und dem Kontaktende die einzelnen koplanaren Leiter (20) der koplanaren Leiterstruktur derart ausgebildet sind, dass sie bzgl. des halternden Dielektrikums (22) federnd angeordnet sind,
**dass** die am Gehäuse (200) vorgesehenen Kontakte (17) wenigstens teilweise als Koaxialverbinder zum Anschluss eines Koaxialkabels ausgebildet sind und
**dass** der Koaxialverbinder (17) als Winkelverbindungselement zum gehäuseseitigen elektrischen Verbinden einer jeweiligen koplanaren Leiterstruktur mit einer koaxialen Wellenleiterstruktur ausgebildet ist und ein koplanarstrukturseitiges Anschlussteil zum Verbinden mit den koplanaren Leitern (20) einer der koplanaren Leiterstrukturen sowie einen koaxialstrukturseitigen Koaxanschluss umfasst, der mit einer Koaxialleitung verbindbar ist, wobei das koplanarstrukturseitige Anschlussteil innerhalb des Außenumfangs des Winkelverbindungselementes mit einem Innenleiterstift des Koaxanschlusses verbunden ist und als planarer Wellenleiter mit definiertem Wellenwiderstand ausgebildet ist, der ein dielektrisches Substrat und einen Streifenleiter aufweist, wobei innerhalb des Gehäuses des Winkelverbindungselementes der Innenleiterstift des Koaxanschlusses durch das Substrat hindurch mit dem Streifenleiter verbunden ist.

2. Gehäuse (200) nach Anspruch 1, **dadurch gekennzeichnet, dass** alle Kontaktleiter planar ausgebildet sind.

3. Gehäuse (200) nach einem der vorhergehenden Ansprüche, **dadurch gekennzeichnet, dass** die koplanaren Kontaktleiter (20) derart ausgebildet sind, dass ihre Impedanz an einem den Kontaktflächen (14) des Substrats (12) zugewandten Ende einer Ausgangsimpedanz an den jeweils kontaktierten Kontaktflächen (14) auf dem Substrat (12) entspricht.

4. Gehäuse (200) nach einem der vorhergehenden Ansprüche, **dadurch gekennzeichnet, dass** die integrierte Schaltung (10) ein Halbleiterchip ist.

5. Gehäuse (200) nach einem der vorhergehenden Ansprüche, **dadurch gekennzeichnet, dass** die integrierte Schaltung (10) ein Computerprozessor (CPU) ist.

6. Gehäuse (200) nach einem der vorhergehenden Ansprüche, **dadurch gekennzeichnet, dass** die am Gehäuse (200) vorgesehenen Kontakte (16) wenigstens teilweise als Stifte zur Oberflächenbefestigung des Gehäuses (200) auf einer Leiterplatte ausgebildet sind.

7. Gehäuse (200) nach einem der vorhergehenden Ansprüche, **dadurch gekennzeichnet, dass** das Dielektrikum (22) beidseitig der koplanaren Leiterstruktur (20) angeordnet ist.

8. Gehäuse (200) nach einem der vorhergehenden Ansprüche, **dadurch gekennzeichnet, dass** zwischen je zwei Leitern (20) wenigstens einer koplanaren Leiterstruktur von dem Kontaktende bis zu den Koaxialverbindem (17) ein jeweiliger Spalt (24) derart ausgebildet ist, dass sich vom Kontaktende bis zu dem Koaxialverbinder (17) ein vorbestimmter konstanter oder vorbestimmt sich ändernder Wellenwiderstand ergibt.

9. Gehäuse (200) nach Anspruch 8, **dadurch gekennzeichnet, dass** der jeweilige Spalt (24) im Bereich des Dielektrikums (22) breiter ausgebildet ist als im Bereich der koplanaren Leiterstruktur ohne Dielektrikum (22).

10. Gehäuse (200) nach einem der vorhergehenden Ansprüche, **dadurch gekennzeichnet, dass** das Dielektrikum (22) als wenigstens ein Quarzblock ausgebildet ist.

11. Gehäuse (200) nach einem der vorhergehenden Ansprüche, **dadurch gekennzeichnet, dass** das Dielektrikum (22) an einer Verbindungsseite mit der koplanaren Leiterstruktur (20) eine sich mit letzterer im Wesentlichen deckende Metallbeschichtung aufweist.

12. Gehäuse (200) nach einem der vorhergehenden Ansprüche, **dadurch gekennzeichnet, dass** das Dielektrikum (22) an einer der koplanaren Leiterstruktur abgewandten Seite vollflächig metallisiert ist.

13. Gehäuse (200) nach einem der vorhergehenden Ansprüche, **dadurch gekennzeichnet, dass** das dielektrische Substrat in dem Koaxialverbinder (17) aus Polytetrafluorethylen ist.

14. Gehäuse (200) nach einem der vorhergehenden Ansprüche, **dadurch gekennzeichnet, dass** der planare Wellenleiter als Mikrostreifenleitung oder koplanare Leitung ausgebildet ist.

15. Gehäuse (200) nach einem der vorhergehenden Ansprüche, **dadurch gekennzeichnet, dass** am Koaxanschluss ein Schraub- oder Klemmanschluss zur Befestigung einer Koaxialleitung vorgesehen ist.

16. Gehäuse (200) nach einem der vorhergehenden Ansprüche, **dadurch gekennzeichnet, dass** der planare Wellenleiter senkrecht zum Koaxanschluss angeordnet ist.

17. Gehäuse (200) nach einem der vorhergehenden Ansprüche, **dadurch gekennzeichnet, dass** wenigstens einige der Kontaktflächen (14) auf dem Substrat (12) wenigstens teilweise als koplanare Leiterstruktur ausgebildet sind.

## Claims

1. Housing (200) comprising a substrate (12), configured for accommodating an integrated circuit (10), wherein the substrate (12) comprises suitable contact surfaces (14) for creating electrically conductive contact connections between the integrated circuit (10) and contacts (16, 17) provided on the housing (200), said contact surfaces being configured for electrically connecting to corresponding contacts on the integrated circuit (10), wherein the housing (200) has an arrangement of contact conductors (18, 20), which are electrically connected to the contacts (16, 17) provided on the housing (200) and coincide with the arrangement of contact surfaces (14) on the substrate (12) in such a way that the contact conductors (18, 20) contact the contact surfaces (14) with a contact end, in each case, wherein at least some of the contact conductors (20) are configured as coplanar conductor structures, wherein on at least one coplanar conductor structure, a dielectric (22) supporting the coplanar conductor structure is arranged over a predetermined section between the contact end and the housing contacts (17) at least on one side, **characterised in that** between the dielectric (22) and the contact end, the individual coplanar conductors (20) of the coplanar conductor structure are configured in such a way that they are arranged elastically in relation to the supporting dielectric (22), that the contacts (17) provided on the housing (200) are at least partially configured as coaxial connectors for connecting a coaxial cable and that the coaxial connector (17) is configured as an angle connecting element for electrical connection on the housing side of a respective coplanar conductor structure to a coaxial waveguide structure and comprises, on the coplanar structure side, a connecting member for connecting to the coplanar conductors (20) of one of the coplanar conductor structures and a coaxial connection on the coaxial connector side, said coaxial connection being connectable to a coaxial line, wherein the connecting member on the coplanar structure side within the external periphery of the angle connecting element is connected to an internal conductor pin of the coaxial connection and is configured as a planar waveguide with a defined wave impedance, which has a dielectric substrate and a strip line, wherein within the housing of the angle connecting element, the internal conductor pin of the coaxial connection is connected through the substrate to the strip conductor.

2. Housing (200) according to claim 1, **characterised in that** all the contact conductors are configured planar.

3. Housing (200) according to one of the preceding claims, **characterised in that** the coplanar contact conductors (20) are configured in such a way that their impedance at an end facing towards the contact surfaces (14) of the substrate (12) corresponds to an output impedance at the respective contacted contact surface (14) on the substrate (12).

4. Housing (200) according to one of the preceding claims, **characterised in that** the integrated circuit (10) is a semiconductor chip.

5. Housing (200) according to one of the preceding claims, **characterised in that** the integrated circuit (10) is a computer processor (CPU).

6. Housing (200) according to one of the preceding claims, **characterised in that** the contacts (16) provided on the housing (200) are at least partially configured as pins for surface fixation of the housing (200) on a circuit board.

7. Housing (200) according to one of the preceding claims, **characterised in that** the dielectric (22) is arranged on both sides of the coplanar conductor structure (20).

8. Housing (200) according to one of the preceding claims, **characterised in that** a gap (24) is configured between each pair of conductors (20) of at least one coplanar conductor structure from the contact end to the coaxial connectors (17), such that from the contact end to the coaxial connector (17), a predetermined constant or a predetermined varying wave impedance results.

9. Housing (200) according to claim 8, **characterised in that** the respective gap (24) is formed broader in the region of the dielectric (22) than in the region of the coplanar conductor structure without dielectric (22).

10. Housing (200) according to one of the preceding claims, **characterised in that** the dielectric (22) is configured as at least one quartz block.

11. Housing (200) according to one of the preceding claims, **characterised in that** on a side for connecting to the coplanar conductor structure (20), the dielectric (22) has metal coating which essentially coincides with the coplanar conductor structure.

12. Housing (200) according to one of the preceding claims, **characterised in that** the dielectric (22) is metallised on the whole surface of a side facing away from the coplanar conductor structure.

13. Housing (200) according to one of the preceding claims, **characterised in that** the dielectric substrate in the coaxial connector (17) is made from polytetrafluoroethylene.

14. Housing (200) according to one of the preceding claims, **characterised in that** the planar waveguide is designed as a microstrip line or a coplanar line.

15. Housing (200) according to one of the preceding claims, **characterised in that** a screw connection or clamping connection is provided at the coaxial connection for fastening a coaxial line.

16. Housing (200) according to one of the preceding claims, **characterised in that** the planar waveguide is arranged perpendicular to the coaxial connection.

17. Housing (200) according to one of the preceding claims, **characterised in that** at least some of the contact surfaces (14) on the substrate (12) are at least partially configured as coplanar conductor structures.

## Revendications

1. Boîtier (200) avec un substrat (12), qui est réalisé pour recevoir un circuit intégré (10), dans lequel, pour établir des jonctions de contact électriquement conductrices entre le circuit intégré (10) et des contacts (16, 17) prévus sur le boîtier (200), le substrat (12) comporte des surfaces de contact correspondantes (14) qui sont réalisées pour la jonction électrique avec des contacts correspondants sur le circuit intégré (10), le boîtier (200) comportant un agencement de lignes de contact (18, 20) qui sont reliées électriquement avec les contacts (16, 17) prévus sur le boîtier (200) et qui se superposent à l'agencement des surfaces de contact (14) sur le substrat (12) de telle façon que les lignes de contact (18, 20) viennent en contact avec les surfaces de contact (14) par une extrémité de contact respective, quelques-unes au moins des lignes de contact (20) étant réalisées sous forme de structures conductrices coplanaires, dans lesquelles, sur au moins une structure conductrice coplanaire et sur un tronçon prédéterminé entre l'extrémité de contact et les contacts de boîtier (17) est agencé, au moins sur un côté, un diélectrique (22) qui retient la structure conductrice coplanaire,
**caractérisé en ce que**
entre le diélectrique (22) et l'extrémité de contact, les lignes coplanaires individuelles (20) de la structure conductrice coplanaire sont réalisées de telle façon qu'elles sont agencées avec effet ressort par rapport au diélectrique (22) qui retient la structure,
**en ce que** les contacts (17) prévus sur le boîtier (200) sont réalisés au moins partiellement sous forme de connecteurs coaxiaux pour le raccordement d'un câble coaxial, et
**en ce que** le connecteur coaxial (17) est réalisé sous forme d'élément de raccordement angulaire pour le raccordement électrique côté boîtier d'une structure conductrice coplanaire respective avec une structure à guide d'onde coaxiale et comprend une pièce de raccordement, côté structure coplanaire, pour le raccordement avec les lignes coplanaires (20) de l'une des structures conductrices coplanaires, ainsi qu'un raccordement coaxial, côté structure coaxiale, susceptible d'être relié à une ligne coaxiale, la partie de raccordement côté structure coplanaire est reliée, à l'intérieur de la périphérie extérieure de l'élément de raccordement angulaire, avec une tige conductrice intérieure du raccord coaxial, et est réalisée sous forme de guide d'onde planaire avec une impédance définie, qui comporte un substrat diélectrique et un conducteur en ruban, et à l'intérieur du boîtier de l'élément de raccordement angulaire, la tige conductrice intérieure du raccord coaxial est reliée au conducteur en ruban à travers le substrat.

2. Boîtier (200) selon la revendication 1, **caractérisé en ce que** toutes les lignes de contact sont réalisées sous forme plane.

3. Boîtier (200) selon l'une des revendications précédentes, **caractérisé en ce que** les lignes de contact coplanaires (20) sont réalisées de telle manière que leur impédance à une extrémité tournée vers les surfaces de contact (14) du substrat (12) correspond à une impédance de sortie au niveau des surfaces de contact (14) respectivement en contact sur le substrat (12).

4. Boîtier (200) selon l'une des revendications précédentes, **caractérisé en ce que** le circuit intégré (10) est une puce à semi-conducteurs.

5. Boîtier (200) selon l'une des revendications précédentes, **caractérisé en ce que** le circuit intégré (10) est un processeur d'ordinateur (CPU).

6. Boîtier (200) selon l'une des revendications précédentes, **caractérisé en ce que** les contacts (16) prévus sur le boîtier (200) sont réalisés au moins partiellement sous forme de tiges pour la fixation en surface du boîtier (200) sur une carte à circuits imprimés.

7. Boîtier (200) selon l'une des revendications précédentes, **caractérisé en ce que** le diélectrique (22) est agencé des deux côtés de la structure conductrice coplanaire (20).

8. Boîtier (200) selon l'une des revendications précédentes, **caractérisé en ce que**, entre deux conducteurs respectifs (20) d'au moins une structure conductrice coplanaire depuis l'extrémité de contact jusqu'aux connecteurs coaxiaux (17) est réalisé un intervalle respectif (24) de telle façon qu'il en résulte une impédance prédéterminée constante ou qui varie de façon prédéterminée depuis l'extrémité de contact jusqu'au connecteur coaxial (17).

9. Boîtier (200) selon la revendication 8, **caractérisé en ce que** l'intervalle respectif (24) est réalisé plus large dans la région du diélectrique (22) que dans la région de la structure conductrice coplanaire sans diélectrique (22).

10. Boîtier (200) selon l'une des revendications précédentes, **caractérisé en ce que** le diélectrique (22) est réalisé sous forme d'au moins un bloc de quartz.

11. Boîtier (200) selon l'une des revendications précédentes, **caractérisé en ce que** le diélectrique (22) présente, au niveau d'une face de liaison avec la structure conductrice coplanaire (20), un revêtement métallique qui se superpose essentiellement à ladite structure.

12. Boîtier (200) selon l'une des revendications précédentes, **caractérisé en ce que** le diélectrique (22) est métallisé sur toute sa surface sur un côté détourné de la structure conductrice coplanaire.

13. Boîtier (200) selon l'une des revendications précédentes, **caractérisé en ce que** le substrat diélectrique dans le connecteur coaxial (17) est en polytétrafluoroéthylène.

14. Boîtier (200) selon l'une des revendications précédentes, **caractérisé en ce que** le guide d'onde planaire est réalisé sous forme de ligne à microbandes ou sous forme de ligne coplanaire.

15. Boîtier (200) selon l'une des revendications précédentes, **caractérisé en ce qu'**une borne à visser ou à coincer est prévue au niveau du raccordement coaxial pour la fixation d'une ligne coaxiale.

16. Boîtier (200) selon l'une des revendications précédentes, **caractérisé en ce que** le guide d'onde planaire est agencé perpendiculairement au raccordement coaxial.

17. Boîtier (200) selon l'une des revendications précédentes, **caractérisé en ce qu'**au moins quelques-unes des surfaces de contact (14) sur le substrat (12) sont réalisées au moins partiellement sous forme de structures conductrices coplanaires.
